Europäisches Patentamt

European Patent Office

Office européen des brevets

(11) Publication number: **0 375 375 A1**

## (12) EUROPEAN PATENT APPLICATION

(21) Application number: 89313307.4

(22) Date of filing: 19.12.89

(51) Int. Cl.5: **G01R 27/02, G01R 31/02**

(30) Priority: 21.12.88 GB 8829838

(43) Date of publication of application:
27.06.90 Bulletin 90/26

(84) Designated Contracting States:
DE ES FR GB IT NL SE

(71) Applicant: **BRITISH AEROSPACE PUBLIC
LIMITED COMPANY**
**11 Strand**
**London WC2N 5JT(GB)**

(72) Inventor: **Ridings, William**
**British Aerospace (Civil Aircraft) Ltd., PO.
Box 5**
**Filton Bristol(GB)**
Inventor: **Reed, Alan**
**British Aerospace (Civil Aircraft) Ltd., PO.
Box 5**
**Filton Bristol(GB)**

(74) Representative: **Newell, William Joseph et al**
**Wynne-Jones, Lainé & James 22 Rodney
Road**
**Cheltenham Gloucestershire GL50 1JJ(GB)**

(54) Loop impedance tester.

(57) A loop impedance tester comprises a clip-on
transformer coil (19) for inducing an alternating volt-
age in a closed, electrically conducting loop (10-13).
The current flow around the loop is sensed using
another clip-on transformer coil (21). The impedance
of the complete loop may be determined by dividing
the voltage induced by the sensed current. Alter-
natively the impedance of part of the loop may be
determined by dividing the voltage drop across said
part by the sensed current.

Fig.1.

# LOOP IMPEDANCE TESTER

This invention relates to a loop impedance tester. More particularly, though not exclusively, it relates to a method and apparatus for measuring the electrical resistance of electrical conduit installations in aircraft.

Protection of electrical systems against the adverse effects of lightning and externally radiated electro-magnetic fields from high energy sources relies on good shielding of the electrical cables and wires that are in exposed areas. Such protection may be afforded by highly conductive raceways of braided/solid conduit but, to be effective, they must be electrically bonded to the main aircraft structure at each extremity. This electrical bonding provides a path for conducted and induced currents to flow in the raceways and/or conduits, which is essential for effective shielding of the installed cables and wires. This is, of course, particularly important in the case of flight critical systems and especially so in what are termed "fly-by-wire" aircraft. If only one end of the conduit and/or raceway is bonded, perhaps due to a high resistance joint at the other attachment point, little or no current flows and the protection is lost.

The ability to accurately measure electrical resistance can give assurance that a complete loop has been formed by the conduit and structure and that low resistance bonds have been manufactured. This in turn gives confidence that the installation will provide protection of flight critical and essential wiring from the effects of lightning strike and electro-magnetic interference.

Known methods of checking the resistance of each bonded joint are not completely satisfactory. It is possible for the resistance of a parallel path to mask the fact that a particular joint has high resistance. However, if current of a given magnitude is known to be flowing in the joint, then the joint resistance can be measured with confidence, by measuring current and voltage.

It is an object of the present invention to provide a method and means for bond testing electrical installations.

According to one aspect of the present invention there is provided a method of testing the impedance of a closed, electrically conducting loop, which comprises causing an electric current to flow around the loop, monitoring the current flow and/or the voltage drop around at least part of the loop, thereby to monitor the impedance of a part of or the whole of the loop.

One embodiment of the invention will now be described, by way of example only, and with reference to the accompanying drawings in which:-

Figures 1 and 2 illustrate schematically one prior art method of testing the electrical bonding resistance between a metal braided conduit and adjacent mounting structure,

Figure 3 illustrates, in principle, one arrangement of testing in accordance with the present invention;

Figure 4 illustrates a practical variation of the arrangement of Figure 3;

Figure 5 illustrates one method and apparatus for conduit testing in accordance with the present invention;

Figure 6 illustrates an alternative method and apparatus for conduit testing in accordance with the present invention, and

Figure 7 illustrates the voltage generator arrangement forming one element of the conduit testing apparatus in accordance with the present invention.

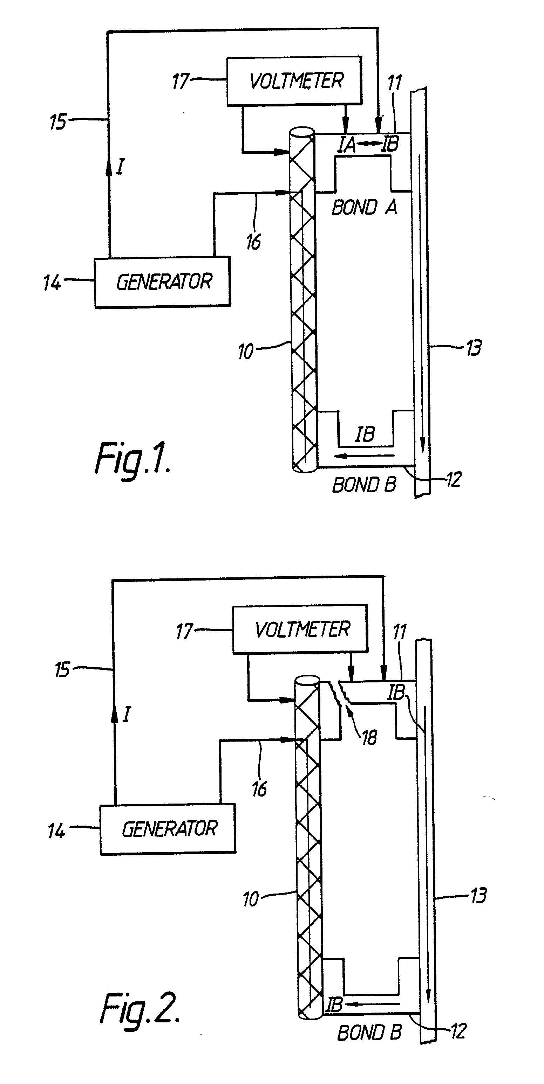

Referring firstly to Figures 1 and 2 these illustrate the connection arrangement associated with one prior art method of testing a braided conduit 10 having bonded attachments 11 and 12 at the respective ends of the conduit to a structural member 13. A voltage generator 14 includes the connection 15 to the attachment 11 and a second connection 16 to the braided conduit 10. A voltmeter 17 is similarly connected to both components as illustrated. Figure 2 schematically illustrates a physical break 18 in the attachment 11.

The voltage generator 14 applies a voltage across the bonded attachment 11 under test which causes a current 'I' to flow and the potential difference 'V' across the joint between the attachment 11 and the conduit 10 is measured. From this a value for the resistance 'P' of the joint is calculated (R = V/I). However, as seen in Figure 1, the current splits into two paths IA and IB, each flowing from the voltage generator 14 through their respective bond points. The subsequent calculation of 'P' uses IA and IB instead of IA alone and an incorrect value of 'R' for the joint under study is therefore obtained.

The example shown in Figure 2, where the joint is totally open circuited, again highlights measurement inaccuracies, since in this case the only current flowing is through attachment 12. However, the voltmeter which is connected across broken attachment 11 will display a reading which may show it as satisfactory. To overcome these errors the true value of IA or IB would need to be known but to find these values is not practicable.

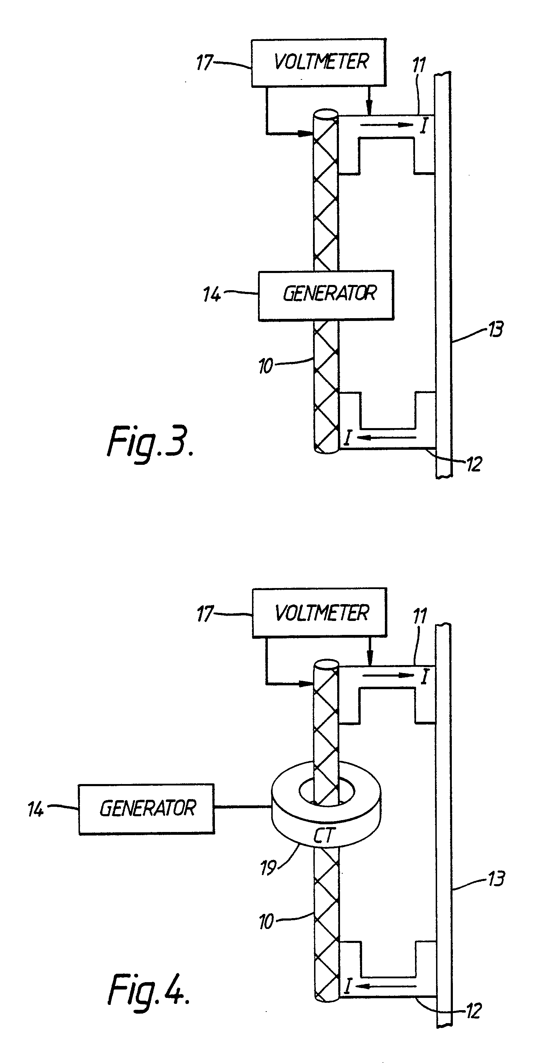

In the following examples of the invention, a test current is induced to flow in around a conductive loop in the structure to be tested rather than being applied to flow between two test probes. One can therefore predict with accuracy the current flowing through the loop (and thus the current flowing through the adjacent attachment) so that subsequent calculations of 'R' will be correct. This is illustrated in principle in Figure 3 but it is of course not practicable to insert a current generator in the conduit or anywhere else in the loop.

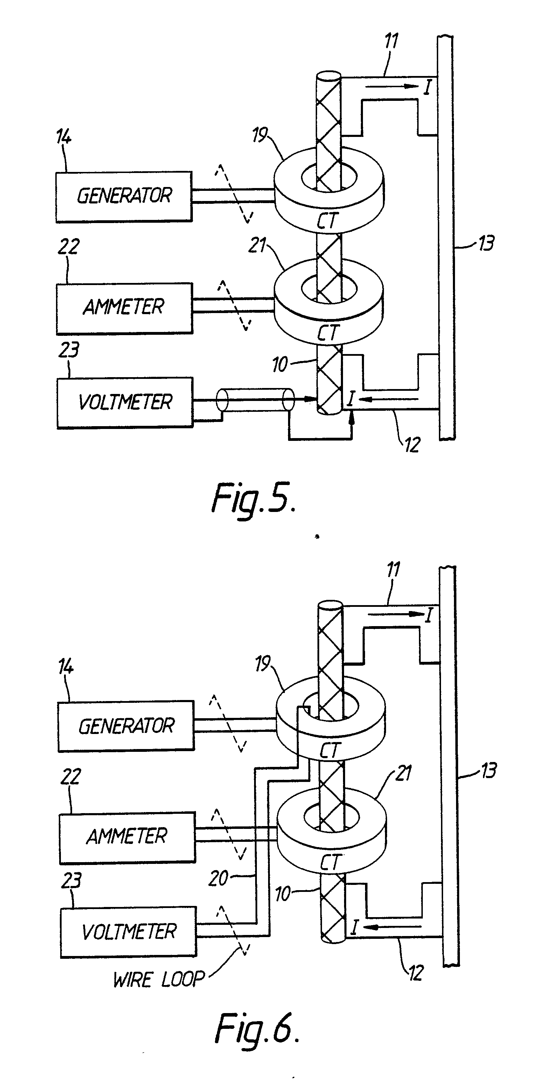

As illustrated in Figure 4, the test current can be induced in the loop formed by the conduit 10, the attachments 11 and 12, and the structure 13, by means of a clip-on transformer 19. The clip-on transformer includes a multiturn coil across which the voltage from generator 14 is applied, and the field generated induces a voltage in the conduit related to that applied to the multiturn coil on the basis of the ratio of turns of the conduit (a single "turn") to the number of turns of the multiturn coil. The method of inducing an alternating current to flow around a complete conductive loop yields two methods of establishing the resistance of the bond points. The first, referring to Figure 5, comprises fitting two clip-on transformers 19 and 21 to the conduit 10 under test, transformer 19 inducing the current in the loop and transformer 21 being the current measuring device connected to an ammeter 22. The voltage applied to the transformer 19 is adjusted so that the current sensed by the transformer 20 is at a suitable value. The calculation of resistance is easy if the voltage is adjusted to provide a current flow I of 1 amp. Once the current has been set, an AC voltmeter 23 can now be used to measure the voltage drop across the individual attachment bond points 11 and 12. Because the current through each bond is known the true value of 'R' can now be calculated ($R = \frac{V}{I}$).

The second method of inducing and measuring the current is similar to the first method, but, as indicated in Figure 6, instead of measuring each bond point with a voltmeter and probes and calculating the resistance of the individual attachments, this method can be used to establish the total resistance of the conduit 10, attachments 11 and 12 and airframe 13.

The generator transformer 19 induces a voltage into the conduit 10 under test via the airframe loop. An external wire loop 20 passed through the centre of the transformer, has induced into it the same voltage as that induced into the conduit 10 and the airframe loop. The total loop resistance is determined by dividing the voltage induced in the loop 20 by the current sensed by the clip on transformer.

In another version, the voltage induced in the conduit is not measured, but is instead estimated by dividing the voltage applied to the transformer by the number of turns in its coil.

The equipment for the above methods of testing is essentially the same, a voltage generator 14 with a clip-on transformer 19, an ammeter 22 with clip-on transformer 21 and a voltmeter 23 with either probes (not shown) or a wire loop 20.

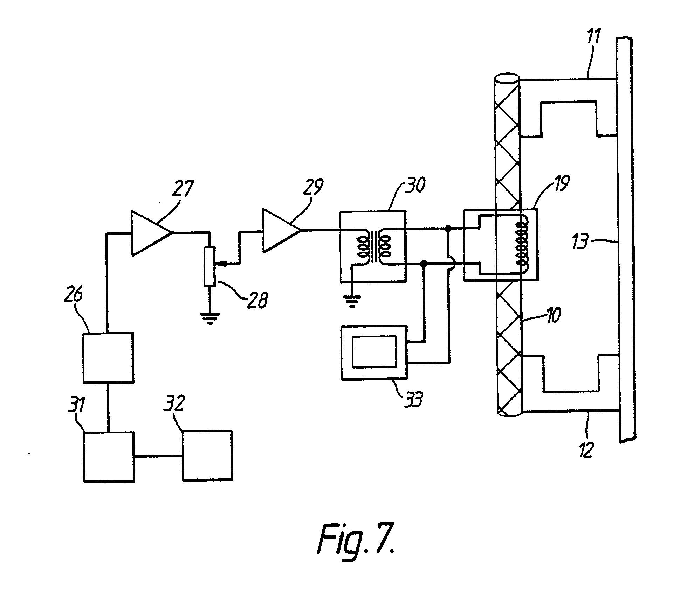

The voltage generator 14 is further discussed in connection with Figure 7 and consists of an oscillator 26 pre-set to a frequency of about 1KHz, the output of which is fed into a buffer amplifier 27 through an amplitude control 28 and thence into a power amplifier 29. The amplifier is then fed into a step-up isolating transformer 30 the secondary of which is connected to the inducing current transformer 19.

The transformer 30 has a tapped winding so that the voltage may be adjusted in steps for course adjustments. Fine adjustments may be made using the amplitude control 28.The voltage applied across the coil may be shown on a display 33.

The equipment is portable and self-powered from 12 volt re-chargeable batteries 31 interconnected to a charger 32.

The operating frequency in the above examples is set at 1KHz. Depending on the particular applications and the performance of the clip-on transformers, higher or lower frequencies may be used. Indeed, the operating frequency may be increased so that the impedance, rather than simply the resistance, of the loop is measured.

## Claims

1. A method of measuring the impedance of a closed electrically conducting loop, which comprises inducing an alternating voltage in the loop and monitoring the current flow, thereby to monitor the impedance of the complete loop.

2. A method of measuring the impedance of a section of a closed, electrically conducting loop, which comprises monitoring the current flow in the loop and the voltage drop across a selected part of the loop, thereby to monitor the impedance of said selected part of the loop.

3. A method according to Claim 1, wherein said current flow is monitored using a sensing coil.

4. A method according to Claim 1, wherein said voltage is induced in the loop by multiturn energisation coil means and the total voltage induced in the loop is deduced from the number of turns of the energisation coil means and the voltage applied thereto.

5. A method according to any preceding Claim,wherein the closed loop is defined by at least one structural member and the monitored impedance is used to determine the structural integrity of said member.

6. A method according to any preceding Claim wherein said current is induced in said loop and sensed using respective clip-on transformer coils.

7. Apparatus for testing the impedance of a closed, electrically conducting loop, comprising first coil means for inducing a voltage in said loop thereby to cause current to flow around the loop, second coil means for monitoring said current flow, and voltage monitoring means for determining the voltage across at least part of said loop.

8. Apparatus according to Claim 7, wherein said first and second coil means each comprise a clip-on transformer coil.

9. Apparatus according to Claim 7 or 8, further including voltage generator means for generating an adjustable voltage for energising said first coil means.

10. Apparatus according to Claims 7, 8 or 9, including display means for displaying the value of the voltage generated across said loop.

11. Apparatus according to any of Claims 7 to 10, including two voltage test probes and means for displaying the voltage between said probes.

17 — VOLTMETER

15

I

14 — GENERATOR

17 — VOLTMETER

10

IA ← IB

BOND A

16

11

13

IB

12

BOND B

*Fig.1.*

15

I

14 — GENERATOR

18

16

10

11

IB

13

IB

12

BOND B

*Fig.2.*

Fig.3.

Fig.4.

Fig.5.

Fig.6.

Fig.7.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 142 143 (DANIEL) <br> * Column 3, line 37 - column 5, line 5; figures 2-4 * | 1,3-4,6,7-9 | G 01 R 27/02 <br> G 01 R 31/02 |
| X | PATENT ABSTRACTS OF JAPAN, vol. 6, no. 229 (P-155)[1107], 16th November 1982; & JP-A-57 131 071 (NIPPON DENSHIN DENWA KOSHA) | 1,3,6,7-8 | |
| X | PATENT ABSTRACTS OF JAPAN, vol. 6, no. 66 (P-112)[944], 27th April 1982; & JP-A-57 8460 (HIOKI DENKI K.K.) | 2 | |
| A | IDEM | 9-11 | |
| A | 1987 IEEE INTERNATIONAL SYMPOSIUM ON ELECTROMAGNETIC COMPATIBILITY, 25th - 27th August 1987, Atlanta Marriott Hotel, US, pages 67-71; L.O. HOEFT et al.: "Development of a cable shield tester for in-situ hardness surveillance of cables" <br> * Page 68, lines 59-73; figure 3 * | 5 | TECHNICAL FIELDS SEARCHED (Int. Cl.5) <br><br> G 01 R 27/00 <br> G 01 R 31/00 <br> G 01 R 15/00 |

The present search report has been drawn up for all claims

| Place of search | Date of completion of the search | Examiner |
|---|---|---|
| THE HAGUE | 20-03-1990 | TRELEVEN C. |